# EUROPEAN PATENT APPLICATION

(11) **EP 3 930 439 A1**
(43) Date of publication of application: **29.12.2021**
(21) Application number: 19916212.4
(22) Date of filing: 19.02.2019
(51) Int. Cl.: H05K 13/08

(54) **REFERENCE MARK IDENTIFICATION DEVICE, AND REFERENCE MARK IDENTIFICATION METHOD**

(71) Applicant: FUJI Corporation, Chiryu-shi, Aichi 472-8686 (JP)
(72) Inventor: SUZUKI, Mikiya, Chiryu-shi, Aichi 472-8686 (JP); KOTANI, Kazuya, Chiryu-shi, Aichi 472-8686 (JP); YOKOI, Yuta, Chiryu-shi, Aichi 472-8686 (JP)
(74) Representative: Grünecker Patent- und Rechtsanwälte PartG mbB
(86) International application number: PCT/JP2019/006162
(87) International publication number: WO 2020/170341

(57) **Abstract**

The object of the present disclosure is to enable satisfactory identifying of a reference mark.

In a present reference mark identification device, a provisional search region is modified to set an actual search region based on each of formation section data, which is data relating to each of one or more formation sections located in the provisional search region provisionally set on a circuit board, and mark data, which is data relating to a reference mark, and it is determined whether each of the one or more formation sections located in the set actual search region is the reference mark. The actual search region can be set, for example, such that the number of formation sections located inside the provisional search region is smaller than the number of formation sections located inside the provisional search region. As a result, the reference mark can be identified better than a case where the reference mark is identified based on the provisional search region.

## Description

### Technical Field

The present disclosure relates to a reference mark identification device and a reference mark identification method for identifying a reference mark from one or more formation sections.

### Background Art

Patent Literature 1 describes a reference mark identification device for identifying reference marks from multiple formation sections formed on a circuit board based on predetermined distances between reference marks to be paired.

### Patent Literature

Patent Literature 1: JP-A-2005-116869

### Summary of the Invention

### Technical Problem

The object of the present disclosure is to enable satisfactory identification of a reference mark.

### Solution to Problem and Advantageous Effect of the Invention

In the reference mark identification device, reference marks are identified from multiple formation sections formed on a circuit board. Based on each of formation section data which is data relating to each of the one or more formation sections located in a provisional search region provisionally set on a circuit board, and mark data which is data relating to a reference mark, a provisional search region is modified to set an actual search region, and it is determined whether each of the one or more formation sections located in the set actual search region is the reference mark. The actual search region can be set such that at least a part of the formation sections located inside that are located at positions different from and similar to the reference mark is to be excluded. As a result, the reference mark can be identified better than a case where the reference mark is identified based on the provisional search region.

### Brief Description of Drawings

FIG. 1 is a plan view showing a mounter to which a reference mark identification device according to an embodiment of the present invention is connected.
FIG. 2 is a side view showing the mounter.
FIG. 3 is a side view (a partial cross-sectional view) illustrating an enlarged view of a principal part of the mounter.
FIG. 4 is a side view showing a vertical lighting device of the mounter.
FIG. 5 conceptually illustrates a control device for controlling the mounter and the periphery of the reference mark determining device.
FIG. 6 (6A) is a plan view showing a circuit board on which components are mounted in the mounter. (6B) is image A of imaging region R of the circuit board.
(6C) illustrates an actual search region set in image A.
FIG. 7 conceptually illustrates CAD data for designing the circuit board.
FIG. 8 conceptually illustrates mark data relating to a reference mark formed on the circuit board.
FIG. 9 illustrates the circuit board.
FIG. 10 illustrates the reference mark.
FIG. 11 illustrates a formation section image which is an image representing a formation section formed on the circuit board.
FIG. 12 is a flowchart illustrating a program to determine the reference mark stored in a storage section of the reference mark identification device.
FIG. 13 is a flowchart illustrating a part of the program to determine the reference mark.
FIG. 14 conceptually illustrates an actual search region different from the actual search region above.
FIG. 15 conceptually illustrates another actual search region different from the actual search region above.
FIG. 16 illustrates a portion of a structure of a circuit board different from the circuit board.

### Description of Embodiments

A reference mark identification device and a mounter to which the reference mark identification device is connected according to one embodiment of the present disclosure will be described in detail based on the drawings. In the present reference mark identification device, a reference mark identification method that is an embodiment of the present disclosure is implemented.

### [First embodiment]

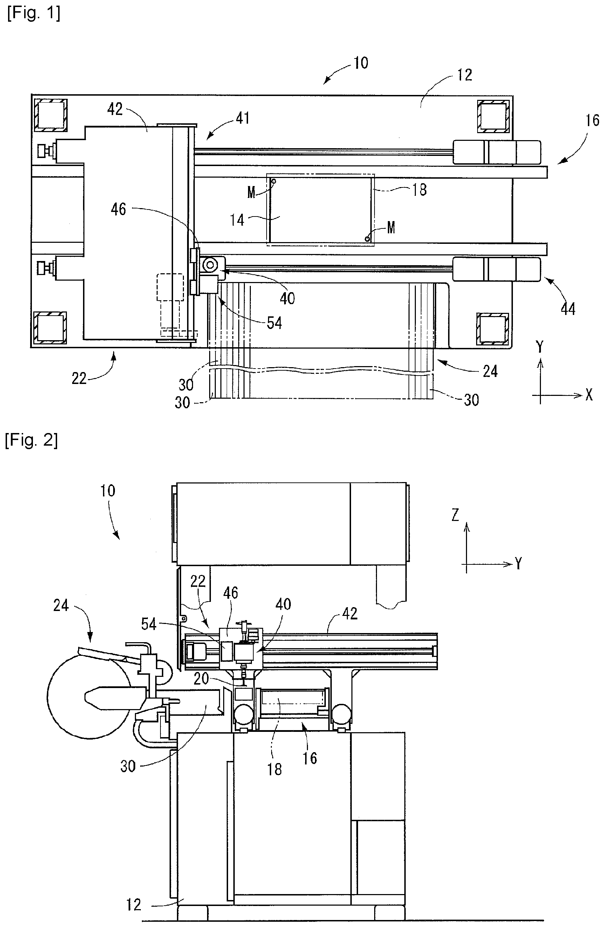

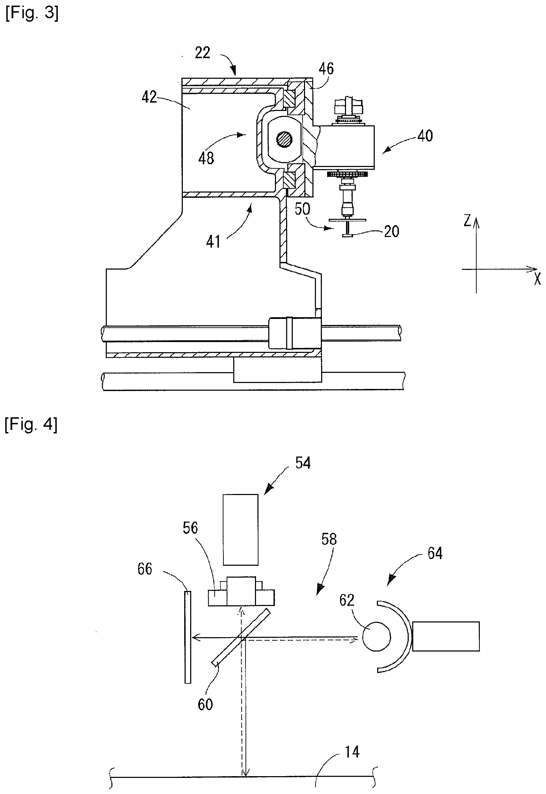

In FIG. 1, reference symbol 12 represents a base serving as a main body of mounter 10. On base 12, board conveyance device 16 for conveying a circuit board 14 (hereinafter, abbreviated as a board)in an X direction, board holding device 18 for holding board 14, a component mounting device 22 for mounting electronic circuit component 20 (refer to FIG. 3, hereunder abbreviated as component 20) on board 14, component supplying device 24 for supplying component 20 to component mounting device 22, and the like are provided. Reference mark M is provided on board 14. It should be noted that a width direction of board 14 is defined as a Y direction, and an up-down direction is defined as a Z direction. The X direction, the Y direction, and the Z direction are orthogonal to each other.

Component supplying device 24 may include, for example, multiple tape feeders 30.

Component mounting device 22 conveys component 20 by component holding head 40 illustrated in FIG. 3, and mounts component 20 to the upper surface of board 14. As illustrated in FIG. 1, component mounting device 22 includes head moving device 41 that moves component holding head 40 to an arbitrary position in a horizontal plane that is a plane parallel to an XY coordinate plane, and head moving device 41 includes X slide 42, X slide moving device 44, Y slide 46, Y slide moving device 48, and the like. X slide moving device 44 moves X slide 42 in the X direction. Y slide 46 is provided on X slide 42, and Y slide moving device 48 relatively moves Y slide 46 in the Y direction on X slide 42.

Component holding head 40, reference mark camera 54 (refer to FIG. 1), annular lighting device 56 (refer to FIG. 4), and vertical lighting device 58 are integrally movably attached to Y slide 46.

Component holding head 40 includes, for example, suction nozzle 50. In suction nozzle 50, component 20 is picked up by a negative pressure, and is mounted to board 14 by releasing the negative pressure.

Reference mark camera 54 is an imaging device for picking up an image of reference mark M or the like formed on board 14, and in this embodiment, is configured by a CCD camera.

As illustrated in FIG. 4, annular lighting device 56 irradiates light around reference mark camera 54 to light reference mark M on board 14 and a portion around reference mark M.

Vertical lighting device 58 includes half mirror 60, light source 64 including halogen lamp 62, and the like. Half mirror 60 is provided below reference mark camera 54 so as to be inclined by 45 degrees with respect to the optical axis of reference mark camera 54. Half mirror 60 is irradiated with light in the horizontal direction from light source 64, and is reflected perpendicularly downward. Symbol 66 represents a non-reflective paper. Non-reflective paper 66 absorbs the light transmitted through half mirror 60.

When reference mark camera 54 images board 14, either annular lighting device 56 or vertical lighting device 58 is selectively used.

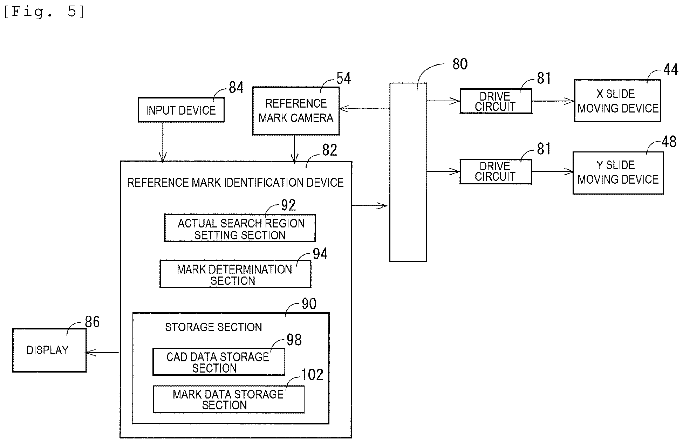

Mounter 10 includes mounter control device 80 illustrated in FIG. 5. Mounter control device 80 is configured mainly by a computer, and an input and output section (not illustrated) are connected to X slide moving device 44, Y slide moving device 48, and the like via drive circuit 81, as well as reference mark camera 54, reference mark identification device 82, and the like.

Reference mark identification device 82 is configured mainly by a computer, and reference mark camera 54, input device 84, display 86, and the like are connected to an input and output section (not illustrated). Reference mark identification device 82 includes storage section 90, actual search region setting section 92, mark determination section 94, and the like. Storage section 90 includes CAD data storage section 98 as a formation section data storage to store CAD data 96 as formation section data, and mark data storage section 102 for storing mark data 100. CAD data 96 is data for creating board 14, that is, design data of board 14 (board design data), and mark data 100 is data relating to reference mark M. CAD data 96, mark data 100, and the like are inputted from an external device (not illustrated) to storage section 90 of reference mark identification device 82 and stored.

In mounter 10 configured as described above, a mounting work of component 20 onto board 14 is performed. Board 14 is transported to a predetermined work position by board conveyance device 16, and is positioned and held by board holding device 18. Reference mark camera 54 is positioned at a predetermined reference mark imaging position, and images a portion of board 14 including reference mark M. The position of reference mark M is acquired by image processing of the captured image, so that a positional error of board 14 is acquired. Thereafter, component holding head 40 receives component 20 from feeder 30, is moved to a predetermined position on board 14, that is, a position corrected based on the positional error, and mounts component 20.

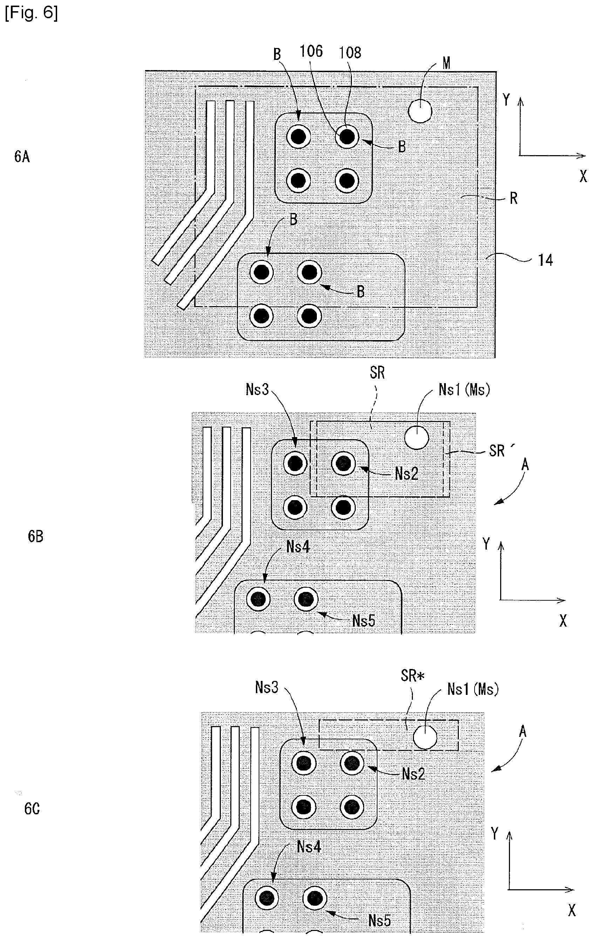

As illustrated in FIG. 6A, imaging region R (imaging region R is determined by reference mark camera 54) which is a portion of board 14 including reference mark M is captured by reference mark camera 54, so that captured image A is acquired as illustrated in FIG. 6B. Since the formation sections of, for example, reference mark M, lead wire inserting section B, wirings, and the like are formed on board 14, captured image A includes multiple formation section images Ns1, Ns2, ... representing formation sections M, B, and the like. Hereinafter, in case it is not necessary to distinguish each other, such as when collectively referring to multiple formation section images Ns1, Ns2, ... , and the like, it may be simply referred to as a formation section image Ns.

Since reference mark M is often formed by exposing a copper foil without applying a solder resist on board 14, mark image Ms (formation section image Ns1) which is an image representing reference mark M often appears white. On the other hand, since lead wire inserting section B includes hole 106 located at the center and land 108 located around hole 106, a center section corresponding to hole 106 appears black, and a periphery section corresponding to land 108 appears white in image Bs (formation section image Ns2) or the like representing lead wire inserting section B.

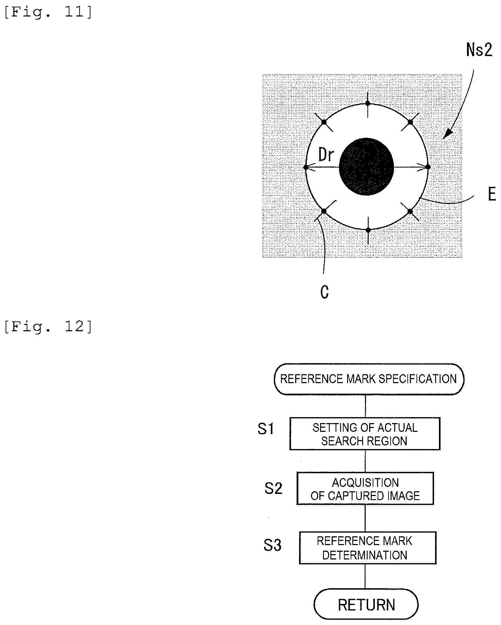

Normally, reference mark M is identified from the multiple formation sections by determining whether each of formation section images Ns1, Ns2 located in search region SR from among multiple formation section images Ns1, Ns2, ... located in captured image A is mark image Ms indicating reference mark M. For example, with respect to formation section image Ns2 (Bs) in captured image A, as illustrated in FIG. 11, edge E of formation section image Ns2 is acquired, for example, by using multiple seek lines C or the like, so that size (diameter) Dr of formation section image Ns2 is acquired. Then, diameter Dr of formation section image Ns2 and mark diameter Dm (considered to be approximately the same as the diameter of mark image Ms) that is the diameter of reference mark M are compared, and in case they are approximately the same, it is considered that formation section image Ns2 is a candidate image that may be determined to be mark image Ms. Then, mark image Ms is identified from one or more candidate images, for example, based on the position or the like of the reference mark.

However, as illustrated in FIG. 11 and FIG. 6B, since formation section image Ns2 has a black center section, a white periphery section, and a size substantially the same as mark image Ms, it is easy to erroneously determine that formation section image Ns2 is mark image Ms.

Accordingly, in the present embodiment, the following is conceived: based on CAD data 96 and mark data 100, a section located in search region SR and easily erroneously determined to be reference mark M of multiple formation sections formed on board 14 is regarded as a similar section, and the actual search region is set such that the similar section is excluded.

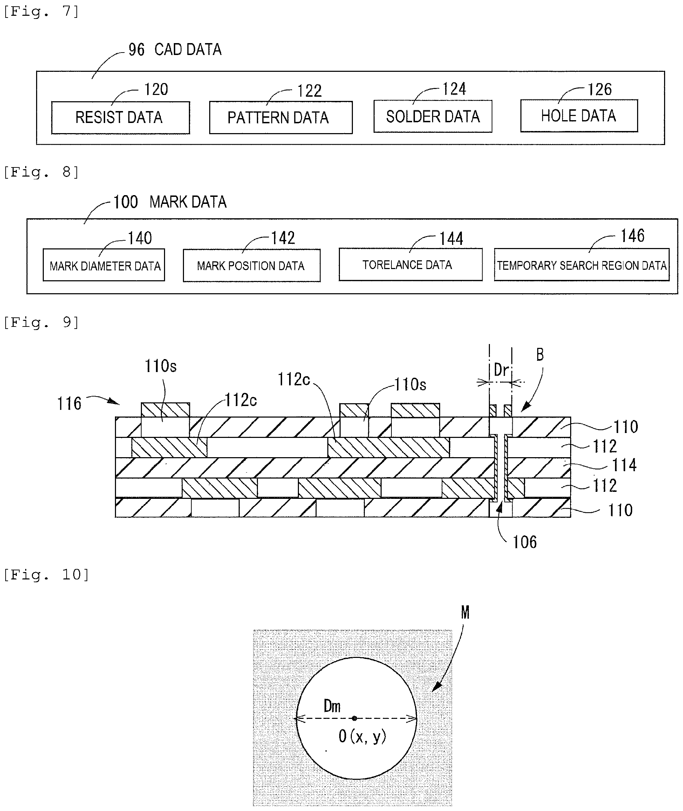

As illustrated in FIG. 9, board 14 includes, for example, resist layer 110, pattern layer 112, insulator layer 114, solder layer 116, and hole 106. Insulator layer 114 is often manufactured of an epoxy resin, a phenolic resin, or the like. Pattern layer 112 is a portion through which electricity flows, and is formed of copper foil. The copper foil is also formed in a portion corresponding to land 108. Resist layer 110 is a layer to which solder resist (e.g., a green paint) is applied. The solder resist is applied for protection, insulation, and the like of pattern layer 112, or in order to prevent the solder from being applied thereto. Solder layer 116 is a layer to which the solder is applied by mask printing or the like. The solder is often applied to a portion to which the solder resist is not applied.

It should be noted that a thickness of each layer is actually very thin, and each layer is not necessarily provided to be clearly separated from each other. However, in FIG. 9, in order to facilitate understanding based on CAD data 96, each layer is illustrated to be thick and separated in the thickness direction.

CAD data 96 includes: resist data 120 which is design data for creating resist layer 110; pattern data 122 which is design data for creating pattern layer 112; solder data 124 which is design data for creating solder layer 116; and hole data 126 which is design data for creating hole 106. Resist data 120 includes data indicating portion 110s (or a portion to be coated) where the solder resist is not applied. For example, in a case where section 110s to which the solder resist is not applied forms a circle, data indicating a position of a center point of that circle and data indicating its diameter (one example of formation section dimension data) are included. Pattern data 122 includes data indicating a position and a size of portion 112c where the copper foil is provided, solder data 124 includes data indicating a position and a size of a portion to which the solder is applied, and hole data 126 includes data indicating a position and a size of hole 106 to be formed.

For example, portion 110s to which the solder resist is not applied, that is, portion 112c where the copper foil is provided in pattern layer 112 and portion 110s to which the solder resist is not applied in resist layer 110 appear white in captured image A. In formation section image Ns2, the center section is black and the periphery section is white, but the outer edge of the white section of the periphery section is determined by section 110s to which the solder resist is not applied. Therefore, based on resist data 120, the size of formation section B, in other words, the size of formation section image Ns2 or the like can be found.

In addition, it is found that hole 106 is located in the interior of formation section B based on resist data 120 and hole data 126. Therefore, it can be considered that hole presence/absence data is configured by resist data 120 and hole data 126.

On the other hand, as illustrated in FIG. 10, mark data 100 that is data on reference mark M includes: mark diameter data 140 as mark dimension data indicating diameter Dm of reference mark M; position data 142 indicating a position (x, y) of center point O of reference mark M; allowance error data (tolerance data) 144 indicating an allowable error (tolerance) of mark diameter Dm; temporary search region data 146 indicating temporary search region SR; and the like.

However, there is a case where search region SR may not be set in advance so as to correspond to reference mark M. In addition, in case search region SR is not set corresponding to reference mark M, imaging region R of reference mark camera 54 is set as search region SR. As described above, search region SR determined in advance from mark data 100, imaging region R determined by reference mark camera 54, and the like are referred to as the temporary search region SR.

In the present embodiment, provisional search region SR' is acquired based on temporary search region SR, and the similar section that is likely to be erroneously determined as reference mark M is detected from one or more formation sections M, B and the like located in a section of board 14 corresponding to provisional search region SR' in captured image A (strictly speaking, the search region is set in captured image A, but hereinafter, a section of board 14 corresponding to the search region set in captured image A is abbreviated as search region of board 14). Then, provisional search region SR' is modified such that at least a part of the similar section is excluded, so that actual search region SR* is set. Then, it is determined whether each of the one or more formed images Ns located in actual search region SR* is mark image Ms, so that the reference mark is identified from one or more formation sections.

The detection of the similar section is performed not based on formation section image Ns but based on resist data 120 and mark data 100 as follows.

From resist data 120 and mark position data 142, a formation section located in provisional search region SR' of board 14 and located at a position different from reference mark M is acquired, diameter Dr of the formation section and mark diameter Dm are acquired from resist data 120 and mark diameter data 140, and it is determined whether an absolute value of a difference between them is equal to or less than tolerance δ. In case the absolute value of the difference between diameter Dr and mark diameter Dm is less than or equal to tolerance δ, the formation section is detected to be the similar section that is similar to reference mark M.

Reference mark M is identified by executing a reference mark identifying program illustrated in a flowchart in FIG. 12.

In Step 1 (hereinafter, abbreviated as S1. In other steps, the same shall apply), actual search region SR* is set, and in step S2, imaging region R of board 14 is imaged by reference mark camera 54, so that captured image A is obtained. In S3, it is determined whether each of formation section images Ns located in actual search region SR* is mark image Ms, and reference mark M is identified. It should be noted that there is a case where in S3, formation section image Ns located in actual search region SR* is one (mark image Ms).

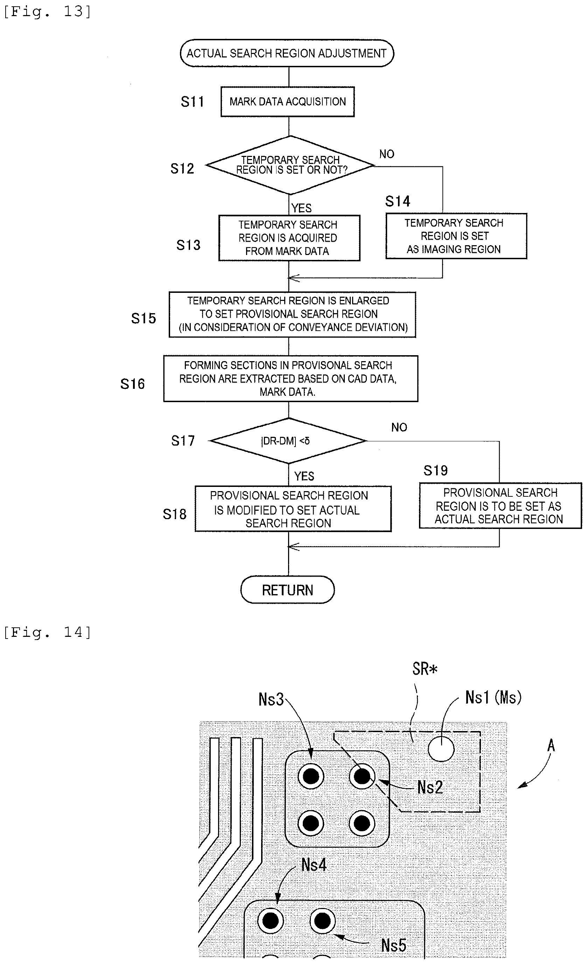

The setting of actual search region SR* in S1 is performed by executing an actual search region setting routine illustrated in a flowchart in FIG. 13.

In S11, mark data 100 is acquired, and in S12, it is determined whether temporary search region data 146 is included in mark data 100. In case it is determined to be YES, temporary search region SR is acquired in S13. In case it is determined to be NO, in S14, imaging region R by reference mark camera 54 is set as temporary search region SR.

Next, in S15, temporary search region SR is enlarged in a conveyance direction (x-direction) in consideration of a conveyance deviation or the like of board 14, so that provisional search region SR' is set. In step S16, one or more formation sections located in provisional search region SR' and located at positions different from reference mark M are extracted based on resist data 120 of CAD data 96, and diameters Dr are acquired, respectively. In S17, it is determined whether the absolute value of the difference between diameter Dr and mark diameter Dm is smaller than tolerance δ. In case it is determined to be NO, in S19, provisional search region SR' is set as actual search region SR*. In case it is determined to be YES, in S18, the formation section is regarded as the similar section, provisional search region SR' is modified such that the similar section is excluded, and actual search region SR* is set.

For example, in the case illustrated in FIGS. 6A, 6B, and 6C, formation section B is located at a position distant from reference mark M in provisional search region SR'. Since the absolute value of the difference between diameter Dr of formation section B and diameter Dm of reference mark M is smaller than tolerance δ, formation section B is considered to be the similar section. Therefore, the y-direction orthogonal to conveyance direction x of board 14 in provisional search region SR' is narrowed such that similar section B is out of actual search region SR*, and actual search region SR* is set. In conveyance direction x of board 14, the positional error of board 14 is larger than in the y-direction orthogonal to conveyance direction x. Therefore, it is desirable to narrow the region in the y-direction where the positional error is small. As illustrated in FIG. 6C, formation section image Ns included in actual search region SR* is one (mark image Ms).

On the other hand, based on resist data 120 and hole data 126, it is found that formation section B has hole 106 therein. Therefore, it is possible to give formation section B to be detected to be the similar section without comparing the diameter of formation section B with mark diameter Dm. This is because lead wire inserting portion B often has a size similar to reference mark M.

As described above, in the present embodiment, the setting of actual search region SR* is automatically performed. It is not necessary for the operator to modify temporary search region SR to set actual search region SR* while viewing captured image A. Therefore, it is possible to reduce the work of the operator.

In addition, in actual search region SR*, the number of similar sections in provisional search region SR' can be reduced (the number of similar sections can be reduced to 0). Therefore, based on actual search region SR* of captured image A, it is possible to make it difficult to erroneously determine that each of formation section images Ns is mark image Ms, so that mark image Ms can be satisfactorily identified from one or more formation section images Ns located in actual search region SR*.

In addition, because of the following, for example: actual search region SR* is narrower than provisional search region SR', and the number of formation section images located in actual search region SR* is reduced, it is possible to shorten a time required to identify reference mark M.

In the above embodiment, although actual search region SR* is set by narrowing of provisional search region SR' in the y-direction, the x-direction which is the conveyance direction can be narrowed.

In addition, it is not indispensable to execute S 15. Temporary search region SR can be made to be provisional search region SR' as it is (SR=SR') without enlarging search region SR and setting provisional search region SR'.

Further, as illustrated in FIG. 14, it is possible to set actual search region SR* by modifying a shape of provisional search region SR'. In this case, a region in which a part of provisional search region SR' is cut out can be used as actual search region SR*. In addition, a part of similar section B may remain in actual search region SR*. Since a part of formation section image Ns2 (Bs) is out of actual search region SR*, it is possible to make it difficult to erroneously determine that the remainder of formation section image Ns2 (Bs) located in actual search region SR* is mark image Ms.

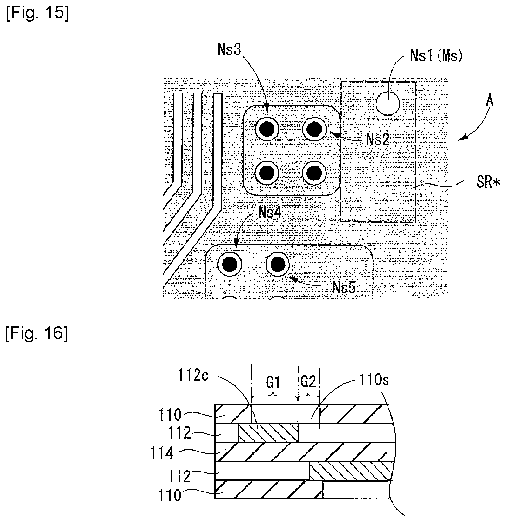

Further, as illustrated in FIG. 15, it is also possible to set actual search region SR* by moving provisional search region SR' without changing the size and shape of provisional search region SR'.

In the above embodiment, the detection of the similar section is performed based on resist data 120 and mark data 100, but the detection of the similar section can be performed based on resist data 120, pattern data 122, and mark data 100. For example, as illustrated in FIG. 16, in pattern layer 112, there may be a portion where portion 112c provided with the copper foil and portion 110s not applied with the solder resist in resist layer 110 do not overlap with each other. In this case, overlapping portion G1 between portion 110s to which the solder resist is not applied and portion 112c where the copper foil is provided appears white, while portion G2 where these do not overlap is black. However, portion G2 may not be distinguishable from the portion to which the solder resist is applied. In this case, section G1 is used as a formation section. The size and position of formation section G1 can be acquired by pattern data 122 and resist data 120.

In addition, it is possible to give the detection of the similar section to be performed based on solder data 124 and mark data 100. As illustrated in FIG. 9, the solder is often coated on the copper foil. Solder data 124 includes data indicating the position and size of a portion to which the solder is applied.

In a case where reference mark M has a polygonal shape, lengths of one side, a diagonal line, and the like of a polygon is set as a dimension of the reference mark, and mark data 100 includes data of the lengths of the one side and the diagonal line of the polygon as the mark dimension data. On the other hand, when the portion to which the solder resist is not applied is the polygon, resist data 120 includes data indicating coordinates of positions of vertices of the polygons of the respective portions. Therefore, the lengths of the side and the diagonal line can be acquired based on the coordinates of the position of the vertex of the polygon. Then, the dimensions of reference mark M and the portion to which the solder resist is not applied are compared with each other, and the similar section is detected.

In the above embodiment, the case is described that the reference mark identification method is executed in the computer connected to mounter control device 80, but can be executed in mounter control device 80.

As described above, in the present embodiment, the similar section detecting section is configured by, for example, parts for storing and for executing S17 of the program in FIG. 13 of reference mark identification device 82, and the search region setting section and the search region narrowing section are configured by, for example, parts for storing and for executing S18. In addition, the execution of S18 corresponds to an actual search region setting step, and the execution of S3 of the program in FIG. 12 corresponds to a mark determination step.

Although several embodiments of the present disclosure have been described above, these are mere examples, and the present disclosure can be practiced in a form where various changes and modifications are made based on the knowledge of those skilled in the art.

### Reference Signs List

54: Reference mark camera 82 : reference mark identification device, 92 : storage section, 94 : actual search region setting section, 96 : mark determination section, 98 : CAD data storage section, 99 : mark data storage section, 96 : CAD data, 100 : mark data, 120 : resist data, 122 : pattern data, 124 : solder data, 140 : mark diameter data, 142 : position data, 146 : temporary search region data

## Claims

1. A reference mark identification device for identifying a reference mark from multiple formation sections formed on a circuit board, the reference mark identification device comprising:
an actual search region setting section configured to modify a provisional search region to set the actual search region based on each of one or more formation section data that is data related to each of one or more formation sections located in the provisional search region that is a search region provisionally set on the circuit board, and mark data that is data related to the reference mark; and
a mark determination section configured to determine whether each of the one or more formation sections located in the actual search region set by the actual search region setting section on the circuit board is the reference mark.

2. The reference mark identification device according to claim 1, wherein the reference mark identification device includes:
a formation section data storage section for storing the one or more formation section data; and
a mark data storage section for storing the mark data,
wherein the actual search region setting section includes a similar section detecting section configured to detect a similar section, of the one or more formation sections located in the provisional search region, that is similar to the reference mark based on each of the one or more formation section data stored in the formation section data storage section and the mark data stored in the mark data storage section, and
wherein the provisional search region is modified such that at least a part of the similar section detected by the similar section detecting section is excluded, to set the actual search region.

3. The reference mark identification device according to claim 2,
wherein the formation section data includes formation section dimension data that is data related to a dimension of a predetermined section of each of the formation sections,
wherein the mark data includes mark dimension data that is data related to a dimension of a setting section that is a predetermined section of the reference mark, and allowable error data indicating an allowable error in a dimension of the setting section of the reference mark, and
wherein the similar section detecting section detects, as the similar section from among the one or more formation sections, a formation section such that an absolute value of a difference between a dimension represented by the formation section dimension data and a dimension represented by the mark dimension data is no more than an allowable error represented by the allowable error data.

4. The reference mark identification device according to claim 2 or 3, wherein the actual search region setting section includes a search region narrowing section that narrows the provisional search region such that at least a part of the similar section included in the provisional search region is excluded.

5. The reference mark identification device according to claim 4, wherein the search region narrowing section reduces a size of the provisional search region in a width direction of the circuit board.

6. The reference mark identification device according to any one of claims 2 to 5,
wherein the actual search region setting section modifies a shape of the provisional search region such that at least a part of the similar section included in the provisional search region is excluded.

7. The reference mark identification device according to any one of claims 2 to 6, wherein the actual search region setting section moves the provisional search region such that at least a part of the similar section included in the provisional search region is excluded.

8. The reference mark identification device according to any one of claims 1 to 7, wherein the formation section data includes hole presence/absence data indicating whether each of the one or more formation sections has a hole, and the actual search region setting section modifies the provisional search region such that at least a part of a formation section having the hole based on the hole presence/absence data is not included of the one or more formation sections included in the provisional search region.

9. The reference mark identification device according to any one of claims 1 to 8, wherein the formation section data includes board design data used when creating the circuit board.

10. The reference mark identification device according to claim 9, wherein the board design data includes design data as to at least one of a resist layer and a pattern layer included in the circuit board.

11. The reference mark identification device according to any one of claims 1 to 10, wherein the search region is an region provided in an captured image acquired by capturing an image of a setting region including the reference mark of the circuit board by an imaging device, and
the mark determination section determines whether each of formation section images, which is an image representing the one or more formation sections located in the actual search region set by the actual search region setting section, among the captured images is a mark image representing the reference mark.

12. A reference mark identification method of identifying a reference mark among each of multiple formation sections formed on a circuit board, the reference mark identification method comprising:
an actual search region setting step to modify the provisional search region to set the actual search region based on each of one or more formation section data that is data related to each of one or more formation sections that are located in a provisional search region that is a search region provisionally set on the circuit board and mark data that is data related to the reference mark; and a mark determination step to determine whether each of the one or more formation sections included in the actual search region set in the actual search region setting step on the circuit board is the reference mark.
